# FASCICULE DE BREVET EUROPEEN

(11) **EP 1 450 407 B1**
(45) Date de publication et mention de la délivrance du brevet: **19.04.2006**
(21) Numéro de dépôt: 04300071.0
(22) Date de dépôt: 10.02.2004
(51) Int. Cl.: H01L 23/528, H01L 23/522

(54) **Circuit à régulateur de tension intégré et son procédé de fabrication**
Integrierte Spannungsreglerschaltung und deren Herstellungsverfahren
Integrated voltage regulating circuit and method of fabrication thereof

(30) Priorité: 11.02.2003 FR 0301624
(43) Date de publication de la demande: 25.08.2004
(73) Titulaire: STMicroelectronics S.A., 92120 Montrouge (FR)
(72) Inventeur: Blisson, Fabrice, 13100 Aix en Provence (FR); Debeurme, Gilles, 13530 Trets (FR)
(74) Mandataire: de Beaumont, Michel

(56) Documents cités:
- EP-A- 1 143 513
- DE-A- 4 327 290
- US-A1- 2002 014 914

## Description

La présente invention concerne l'alimentation de circuits intégrés et, plus particulièrement, l'intégration d'un ou plusieurs régulateurs de tension avec le circuit auquel ils sont chargés de fournir une tension d'alimentation. La présente invention concerne plus précisément les régulateurs continu-continu linéaires. De tels régulateurs comportent essentiellement un étage de commande et un ou plusieurs étages de puissance.

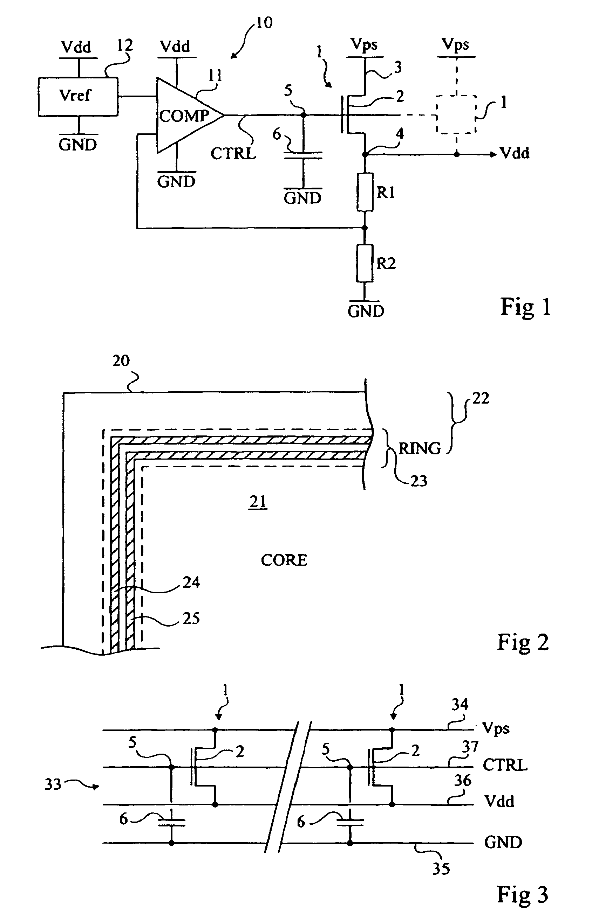

La figure 1 représente, de façon partielle et schématique, un régulateur linéaire du type auquel s'applique la présente invention.

Un étage de puissance 1 est constitué d'un ou plusieurs transistor MOS 2 dont une des bornes de puissance 3 (drain ou source) est connectée à une tension continue d'alimentation Vps et dont l'autre borne de puissance 4 (source ou drain) fournit la tension régulée Vdd. La grille 5 ou borne de commande du transistor de puissance 2 est reliée à la sortie d'un étage de commande 10 du régulateur. Cet étage de commande comprend essentiellement un comparateur 11 (COMP) d'une tension représentative de la tension de sortie régulée Vdd par rapport à une tension de référence Vref. Cette tension de référence est le plus souvent fournie par un circuit 12 communément appelé "bandgap". Dans l'exemple représenté, la tension représentative de la tension de sortie régulée est obtenue au moyen d'un pont diviseur résistif constitué de deux résistances R1 et R2 en série entre la borne 4 et la masse GND. Enfin, un condensateur 6 amortit les variations de la consigne fournie par le comparateur 11 en reliant la grille 5 du transistor 2 à la masse GND. Le circuit 12 et le comparateur 11 sont généralement alimentés par la tension Vdd. Un même étage de commande 10 peut commander plusieurs étages de puissance 1 participant tous à la fourniture de la tension Vdd (bloc 1 représenté en pointillés à la figure 1). Tous ces étages reçoivent alors le même signal de commande CTRL de l'étage 10. De même, au sein d'un même étage de puissance, tous les transistors reçoivent le même signal de commande.

Le principe de fonctionnement d'un régulateur série continu-continu est parfaitement connu de la technique. La notion de transistor de puissance utilisée dans la présente description ne se réfère pas à une haute tension, mais au fait que l'étage de puissance doit véhiculer un courant d'alimentation relativement important (généralement compris entre quelques centaines de microampères et environ 1 ampère) .

Le recours à un régulateur continu-continu dans un circuit intégré est lié à la présence d'une tension d'alimentation Vps, fournie au circuit, qui est supérieure à la tension d'alimentation Vdd des composants internes au circuit.

La tension régulée Vdd est destinée à alimenter différentes fonctions liées à l'application propre au circuit intégré. Les circuits exécutant ces fonctions sont généralement intégrés dans ce que l'on appelle le coeur du circuit alors que le régulateur, et plus précisément ses étages de puissance, peuvent être intégrés dans ce que l'on appelle la couronne du circuit intégré.

La figure 2 représente, par une vue de dessus partielle et schématique, un exemple classique de réalisation d'un circuit intégré 20. Dans l'exemple de la figure 2, le coeur 21 (CORE) du circuit intègre les fonctions liées à l'application ainsi que l'étage ou les étages de commande (non détaillés) des régulateurs de tension. Les étages de puissance du ou des régulateurs de tension sont quant à eux intégrés dans la couronne 22 du circuit intégré. Cette couronne entoure le coeur 21.

La couronne 22 comporte généralement ce que l'on appelle un rail 23 (RING) d'alimentation qui comprend deux conducteurs 24 et 25 véhiculant les potentiels Vps et GND respectivement plus positif et plus négatif d'alimentation du circuit intégré. Le rail d'alimentation peut n'être que partiel en périphérie ou être disposé différemment dans le circuit intégré (par exemple au centre). La notion de coeur englobe, quelle qu'en soit la position, les éléments intégrés remplissant les différentes fonctions liées à l'application propre au circuit intégré et alimentés par un rail de forme quelconque.

Un exemple de circuit intégré dans lequel des étages de puissance de régulation de tension sont disposés dans une couronne d'entrées-sorties d'une puce de circuit intégré est décrit dans la demande de brevet américain n° 2002-0014914. La solution décrite dans ce document consiste à intégrer, dans les emplacements de la couronne destinés aux plots d'entrées-sorties du circuit, les étages de puissance et plus précisément les transistors de puissance des régulateurs. Le rail d'alimentation n'est quant à lui pas touché.

Selon le type de circuit intégré, l'encombrement global de celui-ci peut être lié soit au nombre de circuits du coeur, soit au nombre de plots d'entrées-sorties nécessaires pour ses connexions externes.

Dans le premier cas, on dit que le circuit est de type "Core Limited", ce qui signifie que sa taille est limitée par la surface du coeur du circuit et non par le périmètre nécessaire pour aligner sur ses bords tous les plots d'entrées-sorties. Par conséquent, la surface non utilisée par des plots d'entrées-sorties dans la couronne est récupérée pour le coeur. La réalisation des blocs de puissance dans la couronne réduit d'autant les zones récupérées par le coeur, ce qui a pour conséquence l'augmentation de la taille du circuit.

Dans le cas contraire, lorsque la taille du produit est limitée par l'alignement des plots entrées-sorties et non par la surface du coeur, on dit qu'il est de type "Pad Limited". Pour un nombre de plots d'entrées-sorties constant, la réalisation des blocs de puissance dans la couronne augmente d'autant son périmètre, donc la surface du circuit.

De plus, la surface requise par l'intégration des étages de puissance nécessite, comme cela est décrit dans le document américain cité ci-dessus, la circulation de signaux supplémentaires qui transitent chaque fois du coeur vers la couronne.

La présente invention vise à améliorer les solutions connues en réduisant encore l'encombrement des régulateurs de tension dans des circuits dont le coeur intègre des fonctions applicatives.

L'invention vise notamment à minimiser l'encombrement des étages de puissance de régulation de tension dans des circuits intégrés.

L'invention vise également à minimiser la surface occupée dans la couronne du circuit intégré par l'intégration des étages de puissance des régulateurs de tension.

L'invention vise également à rendre la surface du circuit intégré la plus indépendante possible de la surface des blocs de puissance.

Pour atteindre ces objets et d'autres, la présente invention prévoit un circuit intégré à régulateur continu-continu de tension comprenant au moins un étage de puissance pourvu d'au moins deux transistors et d'au moins un condensateur reliant une électrode de commande du transistor à un potentiel de référence, un même étage de commande du régulateur fournissant un signal de commande desdits transistors, l'étage de puissance étant réalisé sous un rail de distribution de signaux d'alimentation du circuit intégré, ledit rail distribuant au moins deux potentiels extrêmes d'alimentation provenant de l'extérieur du circuit intégré et au moins un potentiel régulé par ledit régulateur de tension.

Selon un mode de réalisation de la présente invention, ledit rail distribue en outre ledit signal de commande.

Selon un mode de réalisation de la présente invention, lesdits transistors sont formés dans une zone active sous-jacente à deux conducteurs voisins de distribution d'un desdits potentiels extrêmes et dudit potentiel régulé.

Selon un mode de réalisation de la présente invention, ledit condensateur est réalisé à l'aplomb d'un conducteur distribuant un potentiel de référence correspondant à l'un desdits potentiels extrêmes.

Selon un mode de réalisation de la présente invention, les électrodes de commande des transistors sont constituées de bandes parallèles conductrices disposées perpendiculairement aux conducteurs dudit rail.

Selon un mode de réalisation de la présente invention, lesdits potentiels sont distribués dans un premier niveau de métallisation du circuit intégré.

Selon un mode de réalisation de la présente invention, ledit étage de commande est réalisé dans un coeur du circuit intégré, autour duquel est disposé ledit rail dans une couronne d'entrées-sorties du circuit.

L'invention prévoit également un procédé de réalisation d'au moins un étage de puissance d'un régulateur de tension constitué d'au moins deux transistors MOS et d'au moins un condensateur reliant une électrode de commande desdits transistor à un potentiel de référence, caractérisé en ce qu'il consiste à former lesdits transistors sous un rail de distribution de signaux d'alimentation du circuit intégré, dans une couronne d'entrées-sorties de celui-ci, ledit rail distribuant au moins ledit potentiel de référence, un potentiel régulé fourni par lesdits étages de puissance et un potentiel d'alimentation de ce dernier.

Selon un mode de réalisation de la présente invention, ledit condensateur est formé sous ledit rail.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1 et 2 décrites précédemment sont destinées à exposer l'état de la technique et le problème posé ;
la figure 3 représente le schéma électrique équivalent d'un rail d'alimentation d'un circuit intégré selon la présente invention ;
la figure 4 est une vue en perspective des niveaux conducteurs utilisés dans un rail d'alimentation selon la présente invention ;
la figure 5 est une vue de dessus de la représentation de la figure 4 ; et
la figure 6 est une vue en coupe du rail d'alimentation selon la ligne VI-VI de la figure 5.

Les mêmes éléments ont été désignés par les mêmes références aux différentes figures. Pour des raisons de clarté, seuls les éléments qui sont nécessaires à la compréhension de l'invention ont été représentés aux figures et seront décrits par la suite. En particulier, les fonctions mises en oeuvre par les circuits intégrés de l'invention n'ont pas été détaillées, celle-ci s'appliquant quelles que soient les fonctions intégrées dans le coeur du circuit. De plus, la réalisation d'un ou plusieurs étages de commande des régulateurs de tension n'a pas été détaillée. Cette réalisation est généralement effectuée dans le coeur du circuit et respecte les réalisations classiques.

Une caractéristique de la présente invention est d'intégrer, sous le rail d'alimentation d'une couronne de circuit intégré, le ou les étages de puissance de régulateur de tension servant à l'alimentation du circuit intégré. Une autre caractéristique de la présente invention est de prévoir, dans le rail d'alimentation périphérique du circuit, au moins trois conducteurs distribuant respectivement les potentiels extrêmes d'alimentation des régulateurs de tension (généralement, la masse et la tension relativement haute d'alimentation) et la tension régulée. De préférence, un quatrième conducteur dans lequel circule un signal de commande commun aux étages de puissance du régulateur ou au moins aux transistors d'un même étage est également présent dans le rail périphérique d'alimentation.

La figure 3 représente, de façon schématique, un rail d'alimentation 33 selon un mode de réalisation préféré d'un circuit intégré selon l'invention. En figure 3, le rail d'alimentation n'a été représenté que par ses conducteurs, et on a fait figurer le schéma électrique des composants des étages de puissance intégrés, selon l'invention, sous ce rail.

Le rail 33 distribue, comme précédemment, deux potentiels extrêmes (Vps et GND) d'alimentation du circuit intégré par deux conducteurs 34 et 35. Le potentiel Vps provient de l'extérieur du circuit et correspond, par exemple, à la tension d'alimentation prélevée sur une carte de circuit imprimé sur laquelle est monté le circuit intégré. Le potentiel GND correspond généralement à la masse du circuit. Bien entendu, il s'agit de potentiels relatifs en ce sens que le circuit pourrait être alimenté par une tension négative par rapport à une masse externe.

Selon la présente invention, le rail 33 d'alimentation distribue également au moins la tension Vdd régulée par un conducteur 36 et, de préférence, un signal CTRL de commande commun aux étages de puissance 1 du régulateur. Ce signal CTRL est véhiculé par un quatrième conducteur 37.

En figure 3, deux étages de puissance 1 d'un transistor chacun ont été représentés. On notera toutefois que, en pratique, un étage de puissance comporte plusieurs transistors. En fait, ce qui importe c'est le nombre de transistors, quel que soit le nombre d'étages dans lesquels ils sont répartis. Pour simplifier on parlera indifféremment d'un étage de puissance ou un transistor. Selon l'invention, le nombre d'étages 1 (donc de transistors) à distribuer dans le rail d'alimentation dépend de la puissance requise pour le coeur du circuit.

Comme précédemment, chaque étage de puissance est constitué de transistors MOS 2 connectés entre les conducteurs 34 et 36, et dont les électrodes de commande 5 (grille) reçoivent le signal CTRL. Du point de vue schéma électrique, chaque transistor 2 est associé à un condensateur 6 connecté entre la grille 5 du transistor et la masse GND (conducteur 35). Le fonctionnement des étages de puissance d'un circuit intégré selon l'invention est identique au fonctionnement décrit précédemment en relation avec la figure 1, à savoir que le signal CTRL module la tension grille-source des transistors 2 pour asservir la tension Vdd sur une référence prédéterminée (non représentée en figure 3).

Selon l'invention, les transistors 2 et condensateurs 6 sont disposés sous les conducteurs du rail d'alimentation. L'invention tire ainsi profit de la surface de substrat disponible sous ce rail pour y réaliser les transistors 2.

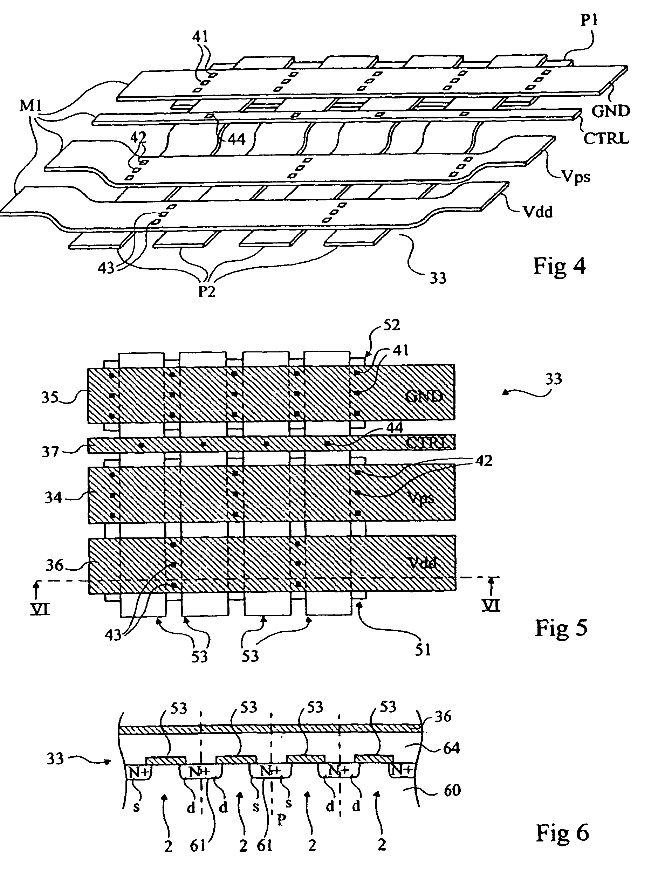

La figure 4 illustre, par une vue partielle en perspective, un mode de réalisation des niveaux conducteurs d'un rail d'alimentation d'un circuit intégré selon la présente invention. La figure 5 représente une vue de dessus du rail 33 de la figure 4. La figure 6 est une vue partielle en coupe selon la ligne VI-VI de la figure 5.

Selon l'invention, on réalise à l'aplomb de la zone prévue pour le rail d'alimentation 33, au moins des transistors 2 constitutifs d'étages de puissance d'un régulateur de tension du circuit. Par exemple (figure 6), les transistors sont des transistors à canal N dont les sources et drains respectifs sont constitués de régions dopées N+ 61 dans un substrat 60 de type P. En figure 5, la zone active dans lesquelles ont été réalisées les régions 61 a été désignée globalement par la référence 51 représentant la zone active des transistors du régulateur. Comme il ressort de cette figure, cette zone active reste contenue dans la largeur du rail d'alimentation 33 et plus particulièrement à l'aplomb des conducteurs 34 et 36 distribuant les potentiels Vps et Vdd correspondant respectivement aux drains et sources des transistors 2.

Après formation des zones actives des transistors, l'électrode des condensateurs 6, côté masse GND, est réalisée dans un premier niveau de silicium polycristallin désigné par la référence P1 en figure 4. Ces électrodes sont constituées d'une bande 52 (figure 5) à l'aplomb du conducteur 35 de masse dans la longueur du rail d'alimentation. La largeur de la bande 52 dépend du dimensionnement souhaité pour les condensateurs 6. La bande 52 est préférentiellement continue sur toute la longueur du rail d'alimentation intégrant des étages de puissance 1 selon l'invention. On prévoit, sous le rail d'alimentation, une zone pour la bande 52 et une zone pour la bande 51 de zones actives dans laquelle sont formés les transistors de puissance 2.

Une fois l'électrode 52 des condensateurs réalisée, on forme, dans un deuxième niveau P2 de silicium polycristallin, les grilles 5 des transistors de puissance 2. Ces grilles sont constituées de bandes conductrices 53 (figure 5) perpendiculaires aux conducteurs 34 à 37 du rail et sont réalisées sur une longueur s'étendant depuis l'aplomb de la zone active 51 jusqu'à l'aplomb de la bande 52 pour définir la deuxième électrode des condensateurs 6. De préférence, le conducteur 37 véhiculant le signal de commande est disposé entre les conducteurs 34 et 35, le conducteur 35 étant réalisé à l'aplomb de la bande 52 et les conducteurs 34 et 36 étant réalisés à l'aplomb de la zone 51.

On notera donc que les tronçons 53 de grille sont d'une longueur correspondant approximativement à la largeur du rail d'alimentation du circuit intégré alors que les autres niveaux conducteurs s'étendant dans l'autre direction (périphérie du circuit intégré) sont préférentiellement continus sur toute la périphérie du circuit, bien que cela n'apparaisse pas aux figures 4 et 5.

Bien entendu, les différents niveaux conducteurs, qu'il s'agisse des niveaux de silicium polycristallin ou du niveau métallique qui seront décrits ultérieurement sont séparés par des couches isolantes adaptées. En particulier, l'épaisseur de la couche isolante séparant les deux niveaux de silicium polycristallin P1 et P2 constitue le diélectrique des condensateurs 6.

Après dépôt d'un niveau isolant 64 (figure 6) sur le niveau P2 de silicium polycristallin, on dépose un premier niveau de métallisation M1 (figure 4) dans lequel sont formés les conducteurs 34 à 37 périphériques du rail d'alimentation.

Comme cela ressort plus particulièrement des figures 4 et 5, les différentes connexions entre les niveaux P1, P2 et M1 sont effectuées au moyen de via de raccordement traversant les couches isolantes correspondantes. La largeur des bandes 53 correspond au paramètre L des transistors. Des vias 41 reliant les niveaux P1 et M1 sont prévus, au droit du rail de masse 35, entre les bandes 53 pour connecter l'électrode de masse des condensateurs 6.

Des vias 42 relient le niveau M1 à la zone active 51 au droit du conducteur 34 d'amenée du potentiel Vps, au niveau des drains d (figure 6) des transistors de puissance 2. Par conséquent, les vias 42 ne sont pas réalisés entre chaque bande 53 de grille mais une bande sur deux. En alternance avec les intervalles dans lesquels sont réalisés les vias 42, on réalise des vias 43 de raccordement de la zone active 51 au niveau des sources s des transistors jusqu'au niveau de métallisation M1, au droit du conducteur 36 de distribution de la tension régulée Vdd. Ainsi, comme cela ressort de la figure 6, les régions 61 dopées N+ communes à deux transistors voisins constituent soit le drain soit la source des deux transistors, en alternance.

Bien que cela n'ait pas été représenté aux figures, les reprises de contact du signal de commande CTRL vers le coeur du circuit intégré pour être connecté à l'étage de commande du régulateur s'effectuent dans d'autres niveaux de métallisation supérieurs, généralement prévus pour le circuit intégré. Comme l'illustrent les figures 4 et 5, des vias 44 relient chaque tronçon 53 de grille au niveau de métallisation M1 au droit du conducteur 37 véhiculant le signal de commande CTRL.

De même, des pistes réalisées dans des niveaux de métallisation supérieurs distribuent le signal de masse GND au coeur du circuit et permettent de raccorder le conducteur 34 de distribution de la tension d'alimentation externe depuis un plot d'entrée-sortie du circuit intégré.

Un avantage de la présente invention est qu'elle minimise la surface occupée par un circuit intégré total en permettant l'intégration des transistors de puissance sous le rail d'alimentation.

Un autre avantage de l'invention est qu'elle ne nécessite aucune étape supplémentaire par rapport au procédé de fabrication habituel du circuit intégré. En effet, la formation de transistors dans la zone active reprend des étapes classiques mises en oeuvre dans le coeur du circuit, de même que les étapes de dépôt et de gravure des différents niveaux de silicium polycristallin et de métallisation.

Le prix à payer pour la mise en oeuvre de l'invention est de disposer de deux niveaux de silicium polycristallin afin de réaliser l'électrode des condensateurs 6 côté masse, avant les grilles 5 des transistors 2.

En variante, les condensateurs 6 peuvent être réalisés directement dans des bandes de zones actives en utilisant des technologies de fabrication de condensateur semi-conducteur de type N. Dans ce cas, on économise un niveau de silicium polycristallin.

Bien entendu, la présente invention est susceptible de diverses variantes et modifications qui apparaîtront à l'homme de l'art. En particulier, les dimensions à donner aux différents conducteurs, zones actives et bandes de silicium polycristallin sont à la portée de l'homme du métier à partir des indications fonctionnelles données ci-dessus et de l'application. De préférence, on cherchera à répartir les transistors de puissance dans le maximum de longueur du rail d'alimentation en fonction de la puissance souhaitée, plutôt que d'élargir ce dernier, afin de minimiser l'encombrement global du circuit.

De plus, et notamment selon la puissance souhaitée, un circuit selon l'invention pourra comporter à la fois des étages de puissance intégrés sous le rail d'alimentation et des étages de puissance intégrés soit dans la couronne hors du rail comme cela est décrit dans la demande américaine citée précédemment, soit directement dans le coeur du circuit intégré.

En outre, l'invention est compatible avec la distribution de plusieurs niveaux de tension Vdd différents dans le circuit intégré. En effet, il suffit pour cela de prévoir des longueurs discontinues de conducteurs 36 et 37 véhiculant respectivement les signaux de commande et la tension régulée. Plusieurs tensions régulées peuvent être ainsi distribuées à différents endroits du circuit intégré. On notera que le fait que le conducteur 36 soit le conducteur placé le plus près du coeur du circuit intégré constitue un mode de réalisation préféré car cela facilite la distribution de la tension régulée au coeur du circuit.

## Revendications

1. Circuit intégré à régulateur continu-continu de tension comprenant au moins un étage de puissance (1) pourvu d'au moins deux transistors (2) et d'au moins un condensateur (6) reliant une électrode de commande (5) du transistor à un potentiel de référence (GND), un même étage de commande (10) du régulateur fournissant un signal (CTRL) de commande desdits transistors, **caractérisé en ce que** l'étage de puissance est réalisé sous un rail (33) de distribution de signaux d'alimentation du circuit intégré, ledit rail distribuant au moins deux potentiels extrêmes (Vps, GND) d'alimentation provenant de l'extérieur du circuit intégré et au moins un potentiel (Vdd) régulé par ledit régulateur de tension.

2. Circuit selon la revendication 1, dans lequel ledit rail (33) distribue en outre ledit signal (CTRL) de commande.

3. Circuit selon la revendication 1 ou 2, dans lequel lesdits transistors (2) sont formés dans une zone active (51) sous-jacente à deux conducteurs (34, 36) voisins de distribution d'un desdits potentiels extrêmes (Vps, GND) et dudit potentiel régulé (Vdd).

4. Circuit selon l'une quelconque des revendications 1 à 3, dans lequel ledit condensateur (6) est réalisé à l'aplomb d'un conducteur (35) distribuant un potentiel de référence correspondant à l'un desdits potentiels extrêmes (Vps, GND).

5. Circuit selon l'une quelconque des revendications 1 à 4, dans lequel les électrodes de commande (5) des transistors (2) sont constituées de bandes parallèles conductrices (53) disposées perpendiculairement aux conducteurs (34, 35, 36, 37) dudit rail (33).

6. Circuit selon l'une quelconque des revendications 1 à 5, dans lequel lesdits potentiels (Vps, Vdd, GND) sont distribués dans un premier niveau de métallisation (M1) du circuit intégré.

7. Circuit selon l'une quelconque des revendications 1 à 6, dans lequel ledit étage de commande (10) est réalisé dans un coeur du circuit intégré, autour duquel est disposé ledit rail (33) dans une couronne d'entrées-sorties du circuit.

8. Procédé de réalisation d'au moins un étage de puissance (1) d'un régulateur de tension constitué d'au moins deux transistors MOS (2) et d'au moins un condensateur (6) reliant une électrode (5) de commande desdits transistors à un potentiel de référence (GND), **caractérisé en ce qu'**il consiste à former lesdits transistors sous un rail (33) de distribution de signaux d'alimentation (Vps, Vdd, GND) du circuit intégré, dans une couronne d'entrées-sorties de celui-ci, ledit rail distribuant au moins ledit potentiel de référence (GND), un potentiel régulé (Vdd) fourni par lesdits étages de puissance et un potentiel (Vps) d'alimentation de ce dernier.

9. Procédé selon la revendication 8, dans lequel ledit condensateur (6) est formé sous ledit rail (33).

## Patentansprüche

1. Integrierter Schaltkreis mit einem Gleichstrom/Gleichstrom-Spannungsregler, der zumindest eine mit mindestens zwei Transistoren (2) ausgestattete Leistungsstufe (1), sowie mindestens einen Kondensator (6) umfaßt, der eine Transistor-Steuerelektrode (5) mit einer Potentialreferenz (GND) verbindet, wobei eine gemeinsame Steuerstufe (10) des Reglers ein Steuersignal (CTRL) für die Transistoren vorsieht, **dadurch gekennzeichnet, daß** die Leistungsstufe unter einer Schiene (33) zur Verteilung der Versorgungssignale des integrierten Schaltkreises ausgebildet ist, wobei die Schiene mindestens zwei Extrempotentiale (Vps, GND), die von außerhalb des integrierten Schaltkreises stammen, und mindestens ein Potential (Vdd) verteilt, das von dem Spannungsregler geregelt wird.

2. Schaltkreis nach Anspruch 1, wobei die Schiene (33) ferner das Steuersignal (CTRL) verteilt.

3. Schaltkreis nach einem der Ansprüche 1 oder 2, wobei die Transistoren (2) in einem aktiven Bereich (51) unterhalb von zwei Leitern (34, 36) benachbart zu dem Verteiler der Extrempotentiale (Vps, GND) und des geregelten Potentials (Vdd) ausgebildet sind

4. Schaltkreis nach einem der Ansprüche 1 bis 3, wobei der Kondensator (6) lotrecht zu einem Leiter (35) angeordnet ist, der ein Referenzpotential verteilt, das einem der Extrempotentiale (Vps, GND) entspricht

5. Schaltkreis nach einem der Ansprüche 1 bis 4, wobei die Steuerelektroden (5) der Transistoren (2) aus parallelen Leiterbahnen (53) ausgebildet sind, die senkrecht zu den Leitern (34,35,36,37) der Schiene (33) angeordnet sind.

6. Schaltkreis nach einem der Ansprüche 1 bis 5, wobei die Potentiale (Vps, Vdd, GND) in einer ersten Metallisierungsebene (M1) des integrierten Schaltkreises verteilt werden.

7. Schaltkreis nach einem der Ansprüche 1 bis 6, in dem die Steuerstufe (10) in einem Kern des integrierten Schaltkreises ausgebildet ist, um den herum die Schiene (33) in einem Eingangs-/Ausgangs-Randabschnitt des Schaltkreises vorgesehen ist.

8. Herstellungsverfahren für mindestens eine Leistungsstufe (1) eines Spannungsreglers, dei mindestens zwei MOS-Transistoren (2) und mindestens einen Kondensator (6), der eine Steuerelektrode (5) der Transistoren mit einem Referenzpotential (GND) verbindet, aufweist, **dadurch gekennzeichnet, daß** das Verfahren das Ausbilden der Transistoren unterhalb einer Schiene (33) zur Verteilung von Versorgungssignalen (Vps, Vdd, GND) des integrierten Schaltkreises innerhalb eines Eingangs-/Ausgangs-Randabschnitts des integrierten Schaltkreises umfaßt, wobei die Schiene mindestens das Referenzpotential (GND), ein von den Leistungsstufen vorgesehenes geregeltes Potential (Vdd) und ein Potential (Vps) zur Versorgung der Leistungsstufen verteilt

9. Verfahren nach Anspruch 8, wobei der Kondensator (6) unterhalb der Schiene (33) ausgebildet ist.

## Claims

1. An integrated circuit with a D.C./D.C. voltage regulator comprising at least one power stage (1) provided with at least two transistors (2) and with at least one capacitor (6) connecting a control electrode (5) of the transistor to a reference voltage (GND), a same control stage (10) of the regulator providing a control signal (CTRL) of said transistors, **characterized in that** the power stage is formed under a rail (33) of provision of supply signals of the integrated circuit, said rail providing at least two limiting supply voltages (Vps, GND) coming from the outside of the integrated circuit and at least one voltage (Vdd) regulated by said voltage regulator.

2. The circuit of claim 1, wherein said rail (33) further provides said control signal (CTRL).

3. The circuit of claim 1 or 2, wherein said transistors (2) are formed in an active area (51) underlying two close conductors (34, 36) of provision of one of the limiting voltages (Vps, GND) and of said regulated voltage (Vdd).

4. The circuit of any of claims 1 to 3, wherein said capacitor (6) is formed straight above a conductor (35) providing a reference voltage corresponding to one of said limiting voltages (Vps, GND).

5. The circuit of any of claims 1 to 4, wherein the control electrodes (5) of the transistors (2) are formed of parallel conductive strips (53) arranged perpendicularly to the conductors (34, 35, 36, 37) of said rail (33).

6. The circuit of any of claims 1 to 5, wherein said voltages (Vps, Vdd, GND) are provided in a first metallization level (M1) of the integrated circuit.

7. The circuit of any of claims 1 to 6, wherein said control stage (10) is formed in a core of the integrated circuit, around which is arranged said rail (33) in a crown of circuit inputs/outputs.

8. A method for forming at least one power stage (1) of a voltage regulator formed of at least two MOS transistors (2) and of at least one capacitor (6) connecting a control electrode (5) of said transistors to a reference voltage (GND), **characterized in that** it comprises forming said transistors under a rail (33) for providing supply signals (Vps, Vdd, GND) of the integrated circuit, in a crown of inputs/outputs thereof, said rail providing at least said reference voltage (GND), a regulated voltage (Vdd) provided by the power stages, and a supply voltage (Vps) thereof.

9. The method of claim 8, wherein said capacitor (6) is formed under said rail (33).
